# EUROPEAN PATENT SPECIFICATION

(11) **EP 4 429 413 B1**
(45) Date of publication and mention of the grant of the patent: **10.12.2025**
(21) Application number: 24162136.6
(22) Date of filing: 07.03.2024
(51) Int. Cl.: H05K 1/02, H05K 1/11

(54) **THERMALLY IMPROVED SUBSTRATE STRUCTURE AND PACKAGE ASSEMBLY WITH THE SAME**
THERMISCH VERBESSERTE SUBSTRATSTRUKTUR UND VERPACKUNGSANORDNUNG DER SELBIGEN
STRUCTURE DE SUBSTRAT THERMIQUEMENT AMÉLIORÉE ET ENSEMBLE BOÎTIER DOTÉ DE CELLE-CI

(30) Priority: 10.03.2023 US 202363489508 P; 04.03.2024 US 202418594573
(43) Date of publication of application: 11.09.2024
(73) Proprietor: MEDIATEK INC., Hsinchu City 30078 (TW)
(72) Inventor: HSIAO, Shu-Wei, 30078 Hsinchu City (TW); LEE, Chung-Fa, 30078 Hsinchu City (TW)
(74) Representative: Haseltine Lake Kempner LLP

(56) References cited:
- JP-B2- 6 699 535
- US-A1- 2003 136 582
- US-A1- 2015 092 374
- US-A1- 2017 290 158
- US-A1- 2022 059 427

## Description

### BACKGROUND OF THE DISCLOSURE

### Field of the Disclosure

The present disclosure relates to a package technology, and in particular to through-hole vias formed at the corners of a substrate structure and a package assembly with the substrate structure.

### Description of the Related Art

Technological advances in IC materials and design have produced generations of ICs where each generation has smaller and more complex circuits than the previous generation. In order to ensure the continued miniaturization and multi-functionality of electronic products and communication devices, semiconductor packages must be small in size, support multi-pin connection, operate at high speeds, and have high functionality. As a result, in the package assembly, more heat may be generated by the semiconductor chip or die.

Accordingly, it is important to address the heat dissipation issue, in order to prevent damage to the electronic devices or the semiconductor chips/dies.

Reference may be made to US 2022/059427 A1 which relates to a semiconductor package, semiconductor device, semiconductor package-mounted apparatus, and semiconductor device-mounted apparatus; US 2017/290158 A1 which relates to a surface-mountable power delivery bus board; US 2003/136582 A1 which relates to a substrate board structure; and US 2015/092374 A1 which relates to solder void reduction between electronic packages and printed circuit boards.

### BRIEF SUMMARY OF THE DISCLOSURE

The present invention relates to a substrate structure. The substrate structure includes an uppermost conductive layer, a first through-hole via (THV) and a second THV, and a first bridge trace. The uppermost conductive layer is adjacent to the top surface of the substrate structure. The uppermost conductive layer includes a first pad portion and at least one second pad portion separated from the first pad portion and arranged near a corner of the first pad portion. The first THV and the second THV are formed in the substrate structure and pass through the substrate structure. The first THV passes through the first pad portion and the second THV passes through the least one second pad portion. The first bridge trace formed in the substrate structure and thermally connected to the second THV and the first THV. The substrate structure further comprises a lowermost conductive layer adjacent to a bottom surface of the substrate structure; and a solder mask layer disposed on the lowermost conductive layer, and comprising at least one opening to expose at least a portion of the second THV and at least a portion of the first THV.

The present invention also relates to a package assembly. The package assembly includes the aforementioned substrate structure and a chip package mounted on the substrate structure.

A detailed description is given in the following embodiments with reference to the accompanying drawings.

### BRIEF DESCRIPTION OF THE DRAWINGS

The present disclosure can be more fully understood by reading the subsequent detailed description and examples with references made to the accompanying drawings, wherein:
FIG. 1 is a top view of an exemplary substrate structure in accordance with some embodiments.
FIG. 2A is a cross-sectional view of the substrate structure along line A-A' shown in FIG. 1 in accordance with some embodiments.

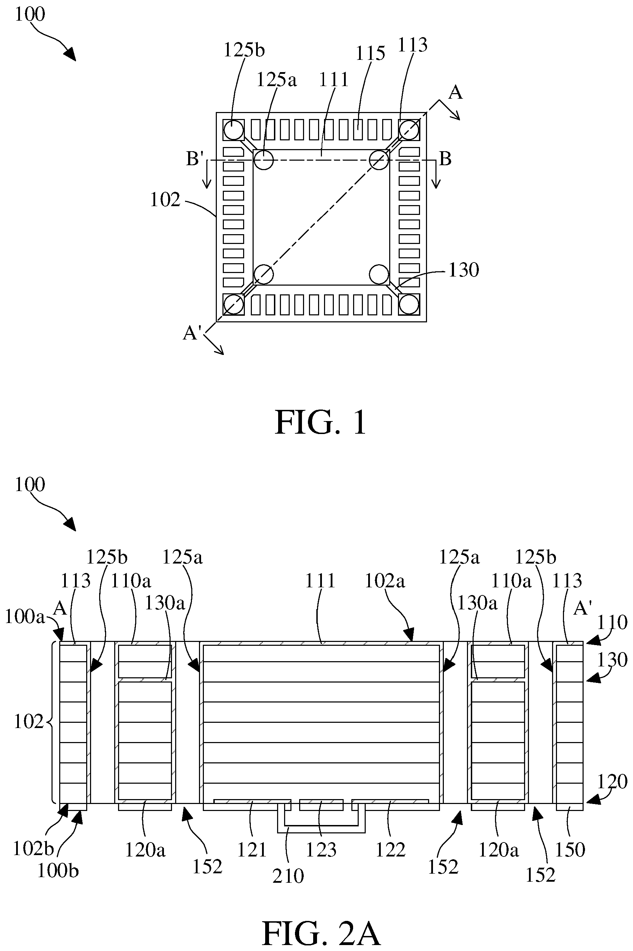

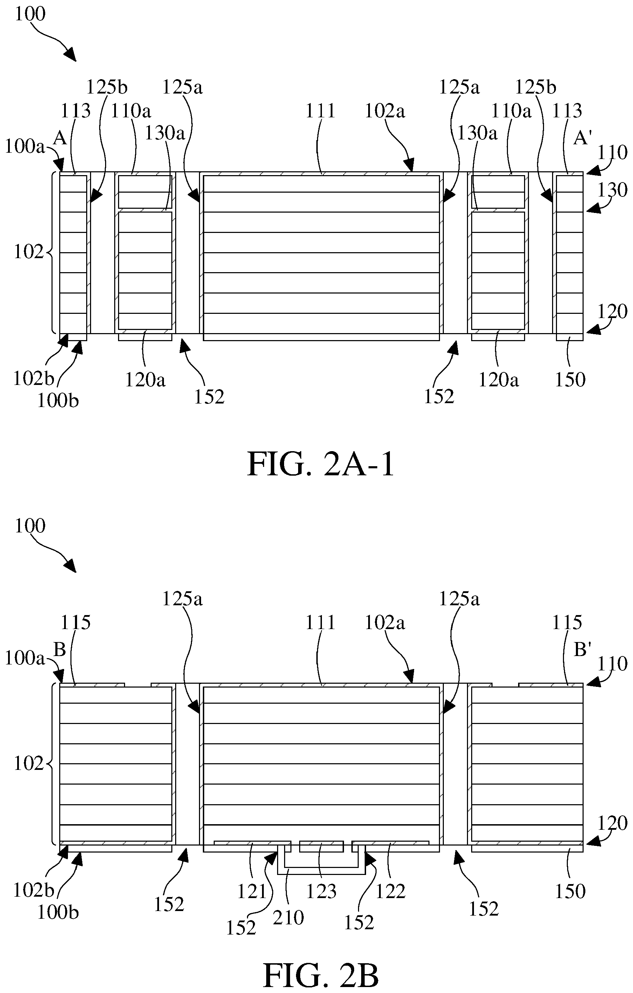

FIG. 2A-1 is a cross-sectional view of the substrate structure along line A-A' shown in FIG. 1 in accordance with some embodiments.

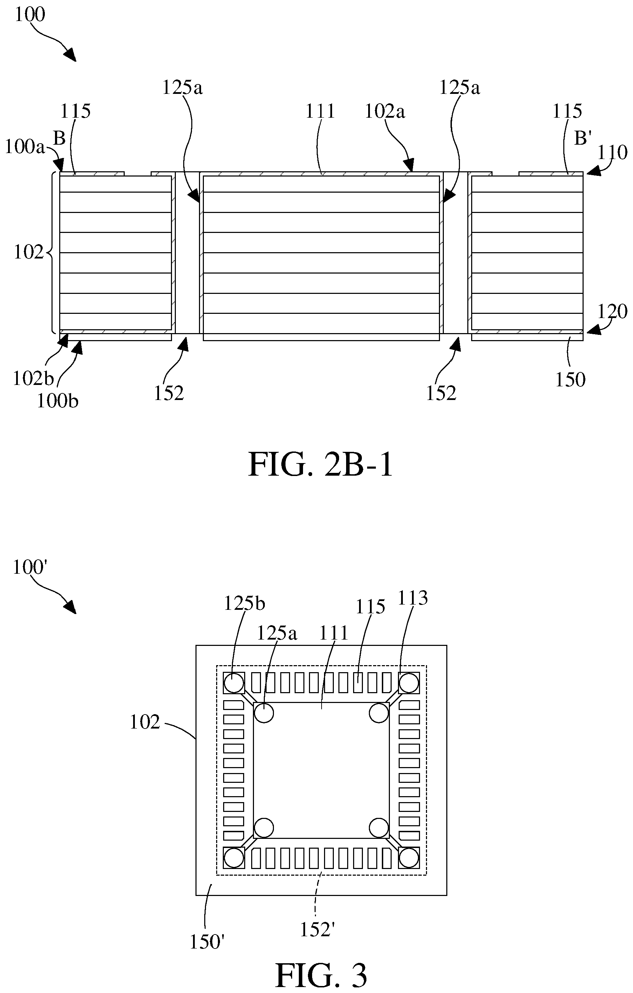

FIG. 2B is a cross-sectional view of the substrate structure along line B-B' shown in FIG. 1 in accordance with some embodiments.
FIG. 2B-1 is a cross-sectional view of the substrate structure along line B-B' shown in FIG. 1 in accordance with some embodiments.
FIG. 3 is a top view of an exemplary substrate structure with a solder mask in accordance with some embodiments.

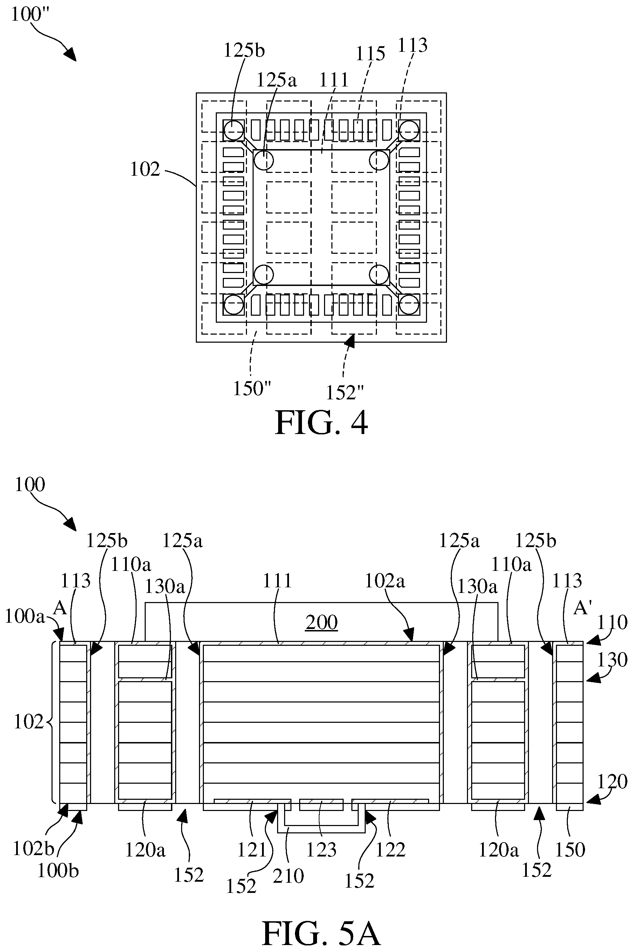

FIG. 4 is a top view of an exemplary substrate structure with a solder mask in accordance with some embodiments.
FIG. 5A is a cross-sectional view of an exemplary package assembly with the substrate structure shown in FIG. 2A in accordance with some embodiments.

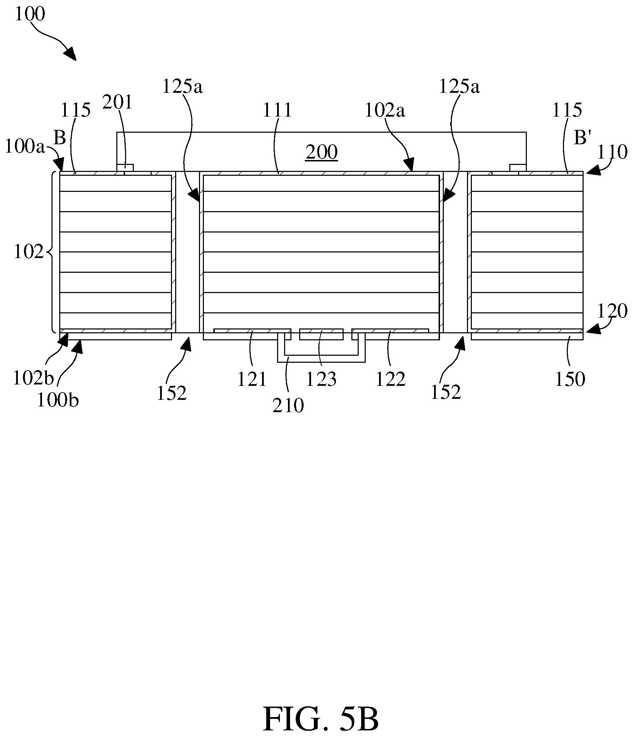

FIG. 5B is a cross-sectional view of an exemplary package assembly with the substrate structure shown in FIG. 2B in accordance with some embodiments.

### DETAILED DESCRIPTION OF THE DISCLOSURE

The following description is of the best-contemplated mode of carrying out the disclosure. This description is made for the purpose of illustrating the general principles of the disclosure and should not be taken in a limiting sense. The scope of the disclosure is determined by reference to the appended claims.

The present disclosure will be described with respect to particular embodiments and with reference to certain drawings, but the disclosure is not limited thereto and is only limited by the claims. The drawings described are only schematic and are non-limiting. In the drawings, the size of some of the elements may be exaggerated for illustrative purposes and not drawn to scale. The dimensions and the relative dimensions do not correspond to actual dimensions in the practice of the disclosure.

The present disclosure provides a substrate structure and a package assembly with the substrate structure. The package assembly includes at least one integrated circuit (IC) chip attached/mounted to a top surface of the substrate structure in, for example, a "Quad Flat No-lead (QFN)" configuration. The IC chip may be one of the many types of IC chips. For example, the IC chip may be a radio-frequency IC (RFIC) chip, a microprocessor chip, an application-specific integrated circuit (ASIC), or a memory chip according to various embodiments.

In some embodiments, the substrate structure may include a core or coreless substrate that may be one of the different types of substrates known to those skilled in the relevant arts (e.g., organic or inorganic substrates). The core or coreless substrate may be made of one or more metal layers with one or more dielectric materials. Trace or routing patterns may be made in the metal layers by, for example, etching the metal layers. The core or coreless substrate may be a single-layer, a two-layer, or multi-layer substrate and may be formed of polypropylene (PP), Pre-preg, FR-4 and/or other epoxy laminate material.

Refer to FIGS. 1, 2A and 2B, in which FIG. 1 is a top view of an exemplary substrate structure 100 in accordance with some embodiments, FIGS. 2A and 2B are cross-sectional views of the substrate structure 100 along lines A-A' and B-B' shown in FIG. 1, respectively, in accordance with some embodiments. In some embodiments, the substrate structure 100 illustrated as a printed circuit board (PCB) and includes a build-up layer structure 102 having a first surface 102a (e.g., top surface) and a second surface 102b (e.g., bottom surface) opposite to the first surface 102a. In some embodiments, the substrate structure 100 further includes a solder mask (not shown) covering the first surface 102a of the build-up layer structure 102. In other embodiments, there is no solder mask disposed on the first surface 102a of the build-up layer structure 102, and the first surface 102a may serve as the top surface 100a of the substrate structure 100. According to the invention the substrate structure 100 includes a solder mask 150 covering the second surface 102b of the build-up layer structure 102, and the bottom surface of the solder mask 150 serves as the bottom surface 100b of the substrate structure 100. In some embodiments, the build-up layer structure 102 may include a core substrate (not shown) and a plurality of alternating laminated conductive layers (not shown) and dielectric layers (not shown) stacked on opposite sides of the core substrate. In some embodiments, the build-up layer structure 102 may be fabricated without the core substrate and include a plurality of alternating laminated conductive layers (not shown) and dielectric layers (not shown). In some embodiments, the alternating laminated conductive layers include a conductive material, such as metals comprising copper, gold, silver, or other applicable metals. In some embodiments, the dielectric layers include Pre-preg or other applicable dielectric materials. In some embodiments, the build-up layer structure 102 may include at least four conductive layers (not shown) and four dielectric layers (not shown).

In some embodiments, the conductive layers of the build-up layer structure 102 layers may be served as pads, ground planes, traces and/or routing patterns for ground/signal/power. For example, the uppermost conductive layer and/or lowermost conductive layer may include pads, ground traces, power traces and signal traces; other conductive layers between the uppermost conductive layer and the lowermost conductive layer may include ground traces, power traces and signal traces. The traces may include signal traces that are used for the input/output (I/O) connections of an overlying package assembly (not shown), and ground traces that are connected to the ground planes. In some embodiments, the pads are connected to different terminals of the traces and used for the package that is mounted directly on them. Moreover, the ground planes are grounded and connected to ground pads of the package assembly. The conductive layers may be made of metal, such as copper, the like, or another suitable conductive material. According to the invention the build-up layer structure 102 of the substrate structure 100 includes a first conductive layer 110 and a second conductive layer 120. The first conductive layer 110 is adjacent to the first surface (top surface) 102a of the build-up layer structure 102 and the second conductive layer 120 is adjacent to the second surface 102b (bottom surface) of the build-up layer structure 102, as shown in FIGS. 2A and 2B. According to the invention the build-up layer structure 102 of the substrate structure 100 includes additional conductive layers between the first conductive layer 110 and the second conductive layer 120, such as a conductive layer 130. The conductive layer 130 may be disposed above the second conductive layer 120 and below the first conductive layer 110.

In some embodiments, the first conductive layer 110 may be an uppermost conductive layer in the build-up layer structure 102 and exposed from the first surface 102a of the build-up layer structure 102. In some embodiments, the first conductive layer 110 may be patterned to form pad pattern portions. For example, the patterned first conductive layer 110 may include a chip pad portion 111, at least one thermal pad portion 113, and signal/power pad portions 115. That is, the chip pad portion 111, the at least one thermal pad portion 113 and the signal/power pad portions 115 are located at the same level in the build-up layer structure 102. In some embodiments, the chip pad portion 111, the at least one thermal pad portion 113 and the signal/power pad portions 115 may be in the first conductive layer 110.

In some embodiments, the chip pad portion (such as first pad portion) 111 may have a rectangular shape with four corners (not limited to these embodiments) and arranged at a central portion of the first surface 102a of the build-up layer structure 102. The chip pad portion 111 is used for attaching an overlying IC chip (not shown). The at least one thermal pad portion (such as second pad portion) 113 is separated from the chip pad portion 111 and arranged near a corresponding corner of the chip pad portion 111. In FIG. 1, four thermal pad portions 113 (not limited to these embodiments) are correspondingly arranged near the four corners of the chip pad portion 111. The thermal pad portions 113 serve as a portion of a heat dissipation structure with the chip pad portion 111. In addition, the thermal pad portions 113 also serve as ground pads in the package substrate 100. In some embodiments, the chip pad portion 111 is used for thermal contact with the thermal pad of the IC chip for heat dissipation of the IC chip. In addition, the chip pad portion 111 is electrically insulated from the signal/power pad portions 115. In some embodiments, the at least one thermal pad portion 113 may be located only near the corner(s) of the chip pad portion 111 and in a peripheral area of the chip pad chip pad portion 111. In some embodiments, the number of thermal pad portions 113 can be one, two, three, or more. In some embodiments, when the shape of the chip pad portion 111 is, for example, a pentagon or a hexagon, the number of thermal pad portions 113 may correspond to the number of corners of the chip pad portion 111, such as five or six. For the sake of convenience in description, the embodiment uses a rectangular chip pad portion 111 as an example, which would result in four thermal pad portions 113. In some embodiments, the first pad portion 111 is configured to bond with an exposed pad of the chip package.

In some embodiments, the signal/power pad portions 115 are also separated from the chip pad portion 111 and arranged along the edges of the chip pad portion 111. In FIG. 1, the signal/power pad portions 115 have a bar shape and arranged side-by-side and along four sides/edges of the chip pad portion 111 (not limited to these embodiments). Moreover, each of the signal/power pad portions 115 has a smaller area than each of the thermal pad portions 113. The signal/power pad portions 115 serve as signal and/or power pads in the package substrate 100. In some embodiments, each thermal pad portion 113 may be positioned between two adjacent groups of signal/power pad portions 115. One group of signal/power pad portions 115 is located along one side/edge of the periphery of the chip pad portion 111, and another group is situated along an adjacent side/edge.

According to the invention the second conductive layer 120 is located at a lower level in the build-up layer structure 102 than the first conductive layer 110. For example, the second conductive layer 120 is a lowermost conductive layer in the build-up layer structure 102 and adjacent to the second surface 102b of the build-up layer structure102. In some embodiments, the second conductive layer 120 is also patterned based on the design demands. In some embodiments, the second conductive layer 120 includes ground traces 121, 122, and at least one power/signal trace 123. The ground traces 121, 122 serves as a portion of a heat dissipation structure and as an electrical ground layer in the substrate structure 100. In some embodiments, the ground trace 121 and ground trace 122 are separated by the power/signal trace 123, so that the ground traces 121 and ground traces 122 are non-continuous structures.

In some embodiments, the substrate structure 100 further includes at least one first through-hole via (THV) 125a and at least one second THV 125b formed in the build-up layer structure 102. The at least one first THV 125a and the at least one second THV 125b pass though the build-up layer structure 102 (or the substrate structure 100). The at least one first THV 125a and the at least one second THV 125b extend from the first surface 102a of the build-up layer structure 102 to the second surface 102b of the build-up layer structure 102, so that the at least one first THV 125a and the at least one second THV 125b are exposed from the first surface 102a and the second surface 102b of the build-up layer structure 102. The at least one first THV 125a is positioned within the build-up layer structure 102 corresponding to the chip pad portion 111, as shown in FIG. 1. In some embodiments, from a top view, the at least one first THV 125a is located within the region of the chip pad portion 111. In some embodiments, there are four THVs 125a disposed at the four corners of the rectangular chip pad portion 111. In some embodiments, at least one first THV 125a is not at the corner of the chip pad portion 125a. In other words, the first THV(s) 125a can be at any position of the chip pad portion 111, which is not limited by the present disclosure. Moreover, each of the first THVs 125a passes through the chip pad portion 111 and the second conductive layer 120, and each of the first THVs 125a is surrounded by and in direct contact with the chip pad portion 111 and the second conductive layer 120, as shown in FIGS. 2A and 2B. In FIG. 1, four first THVs 125a, each with a circular/round shape, are correspondingly positioned within the build-up layer structure 102 at the four corners of the chip pad portion 111, of course, this is just an example, and the solution of the present disclosure is not limited to this. In some embodiments, each of the at least one first THV 125a and the at least one second THV 125b may be formed by plating a thin conductive layer on an inner sidewall of a through hole (not shown) passing through the build-up layer structure 102. Furthermore, each of the at least one first THV 125a and the at least one second THV 125b may be not filled with epoxy resin. The THVs may have a hollow pillar shape.

However, the number, the shape, and the via size of the first THV 125a are based on the design demands and are not limited to these embodiments. For example, two or more first THVs 125a with other shapes (such as square, rectangular, triangular, oval, or polygon) may be arranged in the build-up layer structure 102 and in the chip pad portion 111. In some embodiments, the number of the first THVs 125a can be one, two, three, or more. In some embodiments, when the shape of the chip pad portion 111 is, for example, a pentagon or a hexagon, the number of the first THVs 125a may correspond to the number of corners of the chip pad portion 111, such as five or six; or the number of the first THVs 125a may greater than or less than the number of corners of the chip pad portion 111.

Moreover, similar to the first THVs 125a, the at least one second THV 125b also extends from the first surface 102a of the build-up layer structure 102 to the second surface 102b of the build-up layer structure 102. In some embodiments, each thermal pad portion 113 is disposed near the corner of the corresponding first THV 125a. In some embodiments, the first THV 125a may be disposed adjacent to the corresponding thermal pad portion 113. Specifically, each thermal pad portion 113 is positioned at the corner closest to its corresponding first THV 125a, along with the second THV 125b that is associated with the same thermal pad portion 113. For example, if a single first THV 125a is located at the upper left corner of the chip pad portion 111, then a single second THV 125b would be located at the upper left corner of the corresponding thermal pad portion 113. It is possible for there to be multiple thermal pad portions 113; however, the second THV 125b may only be associated with the thermal pad portion 113 at the upper left corner, while the other thermal pad portions 113 may not having a corresponding second THV 125b. In some embodiments, the first THVs 125a and the second THVs 125b are arranged in a one-to-one correspondence, meaning that the quantity of each can be equal. In some embodiments, there are four second THVs 125b corresponding to the four first THVs125a to improve heat dissipation efficiency. Each of the second THVs 125b is arranged in the build-up layer structure 102 at a corresponding thermal pad portion 113, as shown in FIG. 1. In some embodiments, the first THV(s) 125a may be located at any position of the chip pad portion 111 and is not limited to being located at a corner of the chip pad portion 111. For example, the first THV(s) 125a may be located close to the edge of the chip pad portion 111 or located away from the edge of the chip pad portion 111, and so on. The position and quantity of the first THV(s) 125a can be freely designed according to requirements. In addition, no matter where the first THV(s) 125a is located in the chip pad portion 111, it can be connected to the corresponding second THV(s) 125b through the corresponding bridge trace(s). Moreover, each of the second THVs 125b passes through and is surrounded by and in direct contact with the corresponding thermal pad portion 113, as shown in FIGS. 2A and 2B. In FIG. 1, four second THVs 125b with a circular/round shape are correspondingly arranged in the build-up layer structure 102 at the four thermal pad portions 113. However, the number, the shape, and the via size of the second THV 125b are based on the design demands and are not limited to these embodiments. For example, two or more second THVs 125b with other shape (such as square, rectangular, triangular, oval, or polygon) may be arranged in the build-up layer structure 102 below a corresponding thermal pad portion 113.

In some embodiments, the first THVs 125a and the second THVs 125b serve as portions of a heat dissipation structure. Therefore, the first THVs 125a are also referred to as inner thermal THVs and the second THVs 125b are also referred to as outer thermal THVs. The thermal THVs may be made of metal (e.g., copper) or other suitable thermal conductive materials.

In some embodiments, the substrate structure 100 further includes at least one bridge trace that connects (or thermally connects) each first THV 125a to the corresponding second THV 125b. In some embodiments, the at least one bridge trace may be formed in any one or more conductive layers of the build-up layer structure 102. In some embodiments, the at least one bridge trace may be formed in the first conductive layer 110 (uppermost conductive layer), the second conductive layer 120 (lowermost conductive layer), and/or the conductive layer 130. Each of the bridge traces is thermally connected to and arranged between a corresponding first THV 125a and a corresponding second THV 125b. For example, each of the bridge traces is in physical contact with the corresponding first THV 125a and the corresponding second THV 125b. In some embodiments, the substrate structure 100 further includes bridge traces 110a, 120a and 130a to improve heat dissipation efficiency.

According to the invention the solder mask 150 has at least one opening 152 to expose at least a portion of the first THVs 125a and at least a portion of the second THVs 125b, as shown in FIG. 2A. In some embodiments, the solder mask 150 may be a patterned solder mask (not limited to the embodiments). The at least one opening 152 of the solder mask 150 can further facilitate heat dissipation.

In some embodiments, one or more conductive connectors 210 are electrically connected to the separated portions of the electrical ground trace (e.g., the ground trace 121 and the ground trace 122 of the second conductive layer 120) via the opening(s) 152 of the solder mask 150. In some embodiments, as shown in FIGS. 2A and 2B, because the ground trace 121 and the ground trace 122 are separated by power/signal trace 123 (e.g., making them non-continuous structures), the heat distribution on the ground trace 121 and the ground trace 122 may be unbalanced. Therefore, by connecting the two with the conductive connector 210, heat can be dissipated more evenly, thereby avoiding heat congestion and improving heat dissipation efficiency. In some embodiments, as shown in FIGS. 2A and 2B, the conductive connector 210 passes through the at least one opening 152, and the conductive connector 210 may span the power/signal trace 123 to connect the ground trace 121 and the ground trace 122. Since some or all of the separated ground traces are electrically connected together by the conductive connectors 210, the electrical ground traces can become more complete, so as to enhance the grounding performance thereof. In some embodiments, the conductive connectors 210 are zero-ohm resistors or other suitable metal connecting components.

In some other embodiments, due to the second conductive layer 120 is patterned, the second conductive layer 120 may not formed directly below the chip pad portion 111 corresponding to the line A-A' shown in FIG. 1, as shown in FIG. 2A-1. Similarly, the second conductive layer 120 may not formed directly below the chip pad portion 111 corresponding to the line B-B' shown in FIG. 1, as shown in FIG. 2B-1. As shown in FIGS. 2A and 2B, the ground traces 121, 122 of the patterned second conductive layer 120 serve as the electrical ground layer, and the ground traces 121, 122 are two separate portions. The number of the separated portions of the patterned second conductive layer 120 is based on design demands. In some embodiments, the at least one opening 152 of the solder mask 150 also exposes at least a portion of the ground trace 121 and at least a portion of the ground trace 122.

Refer to FIGS. 3 and 4, in which FIG. 3 is a top view of an exemplary substrate structure 100' with a solder mask 150' in accordance with some embodiments and FIG. 4 is a top view of an exemplary substrate structure 100" with a solder mask 150" in accordance with some embodiments. As shown in FIG. 3, the substrate structure 100' has a structure/configuration similar to that of the substrate structure 100 shown in FIGS. 1, 2A and 2B. Unlike the solder mask 150 of the substrate structure 100, the solder mask 150' has a single large opening 152' that exposes portions of the second surface 102b corresponding to the chip pad portion 111, the thermal pad portions 113, the second THVs 125b, and the signal/power pad portions 115, as viewed from a top-view perspective. In some embodiments, the first THVs 125a and the second THVs 125b may entirely exposed from single large opening 152'. In some embodiments, at least one portion of the ground traces 121/122 is exposed by the single large opening 152'. In some embodiments, the ground traces 121/122 may be entirely exposed from the single large opening 152'.

As shown in FIG. 4, the substrate structure 100" also has a structure/configuration similar to that of the substrate structure 100 shown in FIGS. 1, 2A and 2B. Unlike the solder mask 150' of the substrate structure 100', the solder mask 150" has a plurality of openings 152", the plurality of openings 152" are separated from each other and arranged in a matrix, as viewed from a top-view perspective. In some embodiments, the first THVs 125a and the second THVs 125b may entirely or partially exposed from the plurality of openings 152". In some embodiments, at least one portion of the ground traces 121/122 is exposed by the plurality of openings 152". In some embodiments, the openings in the solder mask may vary in shape and arrangement. According to the invention the openings (openings 152") in the solder mask layer expose at least a portion of the THVs (THV 125a and/or THV 125b) and in some embodiments at least a portion of the ground traces (ground trace 121 and/or ground trace 122), thereby enhancing heat dissipation efficiency.

Refer to FIGS. 5A and 5B, in which 5A and 5B are cross-sectional views of an exemplary package assembly 500 with the substrate structure 100 shown in FIGS. 2A and 2B, respectively, in accordance with some embodiments. As shown in FIGS. 5A and 5B, the package assembly 500 includes a chip package 200 (which is also referred to as an IC chip) mounted on the substrate structure 100 (as shown in FIG. 2A). The chip package 200 is also electrically connected to the signal/power pad portions 115 via leads 201 of the chip package 200. In some embodiments, the chip package 200 is a QFN package that includes an exposed pad correspondingly bonded to the chip pad portion 111 of the substrate structure 100 for thermal conduction. In some other embodiments, the exposed pad of the chip package 200 is electrically insulated from the leads 201 of the chip package 200. In some other embodiments, the chip package 200 is a chip scale package (CSP) and is bond to the die pad portion 111 of the substrate structure 100.

In some embodiments, the package assembly 500 further includes one or more conductive connectors 210 electrically connected to the separated portions of the electrical ground trace (e.g., the ground trace 121 and the ground trace 122 of the second conductive layer 120) via the at least one opening of the solder mask 150. In some embodiments, as shown in FIGS. 5A and 5B, because the ground trace 121 and the ground trace 122 are separated by power/signal trace 123 (e.g., making them non-continuous structures), the heat distribution on the ground trace 121 and the ground trace 122 may be unbalanced. Therefore, by connecting the two with the conductive connector 210, heat can be dissipated more evenly, thereby avoiding heat congestion and improving heat dissipation efficiency. In some embodiments, as shown in FIGS. 5A and 5B, the conductive connector 210 passes through the at least one opening, and the conductive connector 210 may span the power/signal trace 123 to connect the ground trace 121 and the ground trace 122. Since some or all of the separated ground traces are electrically connected together by the conductive connectors 210, the electrical ground traces can become more complete, so as to enhance the grounding performance thereof. In some embodiments, the conductive connectors 210 are zero-ohm resistors or other suitable metal connecting components.

According to the foregoing embodiments, the substrate structure is designed to fabricate a heat dissipation structure integrated into the substrate structure (e.g., PCB). More specifically, the heat dissipation structure is formed in an build-up layer structure of the substrate structure and at least includes a thermal pad arranged near to at least one corner of the chip pad, an outer thermal THV and an inner thermal THV respectively passes through the thermal pad and the chip pad, at least one conductive bridge layer that is connected between the outer thermal THV and the inner thermal THV, and an electrical ground layer thermally connected to the outer thermal THV and the inner thermal THV. The heat dissipation structure allows the package assembly to effectively conduct the heat from the chip package mounted on the top of the substrate structure to the bottom of the substrate structure. Furthermore, the solder mask formed on the bottom of the substrate structure has openings to facilitate heat dissipation. As a result, the heat dissipation efficiency can be increased.

According to the foregoing embodiments, the conductive connectors (e.g., zero-ohm resistors) are employed to connect the discontinuous ground layer in the substrate structure. As a result, the completeness of the ground layer can be increased, thereby enhancing the grounding performance and the heat dissipation efficiency.

## Claims

1. A substrate structure (100, 100'), comprising:
an uppermost conductive layer (110) adjacent to a top surface (100a) of the substrate structure (100, 100'), wherein the uppermost conductive layer (110) comprises:
a first pad portion (111); and
at least one second pad portion (113) separated from the first pad portion (111) and arranged near a corner of the first pad portion (111);
a first through-hole via, THV, and a second THV (125b) formed in the substrate structure (100, 100') and passing through the substrate structure (100, 100'), wherein the first THV (125a) passes through the first pad portion (111) and the second THV (125b) passes through the least one second pad portion (113); and
a first bridge trace (110a, 120a, 130a) formed in the substrate structure (100, 100') and thermally connected to the second THV (125b) and the first THV (125a);
**characterized in that** the substrate structure (100, 100') further comprises:
a lowermost conductive layer (120) adjacent to a bottom surface (100b) of the substrate structure (100, 100'); and
a solder mask (150, 150', 150") layer disposed on the lowermost conductive layer (120), and comprising at least one opening (152, 152', 152") to expose at least a portion of the second THV (125b) and at least a portion of the first THV (125a).

2. The substrate structure (100, 100') as claimed in claim 1, wherein the first bridge trace (110a, 120a, 130a) is formed in the uppermost conductive layer (110) or in another conductive layer (120, 130) of the substrate structure (100, 100') that is below the uppermost conductive layer (110).

3. The substrate structure (100, 100') as claimed in claim 2, further comprising:
a second bridge trace (120a, 130a) thermally connected to the second THV (125b) and the first THV (125a), and formed in a conductive layer (120, 130) of the substrate structure (100, 100') that is different from the conductive layer (110) in which the first bridge trace is (110a) formed.

4. The substrate structure (100, 100') as claimed in claim 1, wherein the lowermost conductive layer (120) comprises a first ground trace (121, 122), wherein the at least one opening (152, 152', 152") further exposes at least a portion of the first ground trace (121, 122).

5. The substrate structure (100, 100') as claimed in claim 4, wherein the lowermost conductive layer (120) further comprises a power/signal trace (123) and a second ground trace (121, 122) separated from the first ground trace (121, 122) by the power/signal trace (123), wherein the power/signal trace (123) is covered by the solder mask (150, 150', 150") layer, and at least a portion of the second ground trace (121, 122) is exposed from the at least one opening (152, 152', 152").

6. The substrate structure (100, 100') as claimed in claim 5, further comprising:
a conductive connector (210) electrically coupling the first ground trace (121, 122) and the second ground trace (121, 122),
wherein the conductive connector (210) passes through the at least one opening (152, 152', 152"), and further spans the power/signal trace (123).

7. The substrate structure (100, 100') as claimed in claim 1, wherein the first bridge trace (110a, 120a, 130a) is connected to an electrical ground layer in the substrate structure (100, 100').

8. The substrate structure (100, 100') as claimed in claim 1, wherein the at least one opening (152, 152', 152") is a single opening (152') that entirely exposes the second THV (125b) and the first THV (125a).

9. The substrate structure (100, 100') as claimed in claim 1, wherein the solder mask (150, 150', 150") layer includes a plurality of openings (152") that are spaced apart from each other to form a matrix of openings (152").

10. A package assembly (500), comprising:
a substrate structure (100, 100') of any one of claims 1 to 9; and
a chip package (200) mounted on the substrate structure (100, 100').

## Patentansprüche

1. Substratstruktur (100, 100'), umfassend:
eine oberste leitfähige Schicht (110), die einer oberen Oberfläche (100a) der Substratstruktur (100, 100') benachbart ist, wobei die oberste leitfähige Schicht (110) Folgendes umfasst:
einen ersten Flächenabschnitt (111); und
mindestens einen zweiten Flächenabschnitt (113), der von dem ersten Flächenabschnitt (111) getrennt und in der Nähe einer Ecke des ersten Flächenabschnitts (111) angeordnet ist;
eine erste Durchkontaktierung, THV, und eine zweite THV (125b), die in der Substratstruktur (100, 100') gebildet sind und durch die Substratstruktur (100, 100') hindurchführen, wobei die erste THV (125a) durch den ersten Flächenabschnitt (111) und die zweite THV (125b) durch den mindestens einen zweiten Flächenabschnitt (113) hindurchführt; und
eine erste Brückenbahn (110a, 120a, 130a), die in der Substratstruktur (100, 100') gebildet sind und thermisch mit der zweiten THV (125b) und der ersten THV (125a) verbunden ist;
**dadurch gekennzeichnet, dass** die Substratstruktur (100, 100') ferner Folgendes umfasst:
eine unterste leitfähige Schicht (120), die einer unteren Oberfläche (100b) der Substratstruktur (100, 100') benachbart ist; und
eine Lötmaskenschicht (150, 150', 150"), die auf der untersten leitfähigen Schicht (120) angeordnet ist und mindestens eine Öffnung (152, 152', 152'') umfasst, um mindestens einen Abschnitt der zweiten THV (125b) und mindestens einen Abschnitt der ersten THV (125a) freizulegen.

2. Substratstruktur (100, 100') nach Anspruch 1, wobei die erste Brückenbahn (110a, 120a, 130a) in der obersten leitfähigen Schicht (110) oder in einer anderen leitfähigen Schicht (120, 130) der Substratstruktur (100, 100') gebildet ist, die sich unterhalb der obersten leitfähigen Schicht (110) befindet.

3. Substratstruktur (100, 100') nach Anspruch 2, ferner umfassend:
eine zweite Brückenbahn (120a, 130a), die thermisch mit der zweiten THV (125b) und der ersten THV (125a) verbunden ist und in einer leitfähigen Schicht (120, 130) der Substratstruktur (100, 100') gebildet wird, die sich von der leitfähigen Schicht (110) unterscheidet, in der die erste Brückenbahn (110a) gebildet ist.

4. Substratstruktur (100, 100') nach Anspruch 1, wobei die unterste leitfähige Schicht (120) eine erste Massebahn (121, 122) umfasst, wobei die mindestens eine Öffnung (152, 152', 152") ferner mindestens einen Abschnitt der ersten Massebahn (121, 122) freilegt.

5. Substratstruktur (100, 100') nach Anspruch 4, wobei die unterste leitfähige Schicht (120) ferner eine Strom-/Signalbahn (123) und eine zweite Massebahn (121, 122) umfasst, die von der ersten Massebahn (121, 122) durch die Strom-/Signalbahn (123) getrennt ist, wobei die Strom-/Signalbahn (123) von der Lötmaskenschicht (150, 150', 150") bedeckt ist und mindestens ein Abschnitt der zweiten Massebahn (121, 122) aus der mindestens einen Öffnung (152, 152', 152") freigelegt ist.

6. Substratstruktur (100, 100') nach Anspruch 5, ferner umfassend:
einen leitfähigen Verbinder (210), der die erste Massebahn (121, 122) und die zweite Massebahn (121, 122) elektrisch koppelt,
wobei der leitfähige Verbinder (210) durch die mindestens eine Öffnung (152, 152', 152") hindurchführt und sich ferner über die Strom-/Signalbahn (123) erstreckt.

7. Substratstruktur (100, 100') nach Anspruch 1, wobei die erste Brückenbahn (110a, 120a, 130a) mit einer elektrischen Masseschicht in der Substratstruktur (100, 100') verbunden ist.

8. Substratstruktur (100, 100') nach Anspruch 1, wobei die mindestens eine Öffnung (152, 152', 152") eine einzelne Öffnung (152') ist, die die zweite THV (125b) und die erste THV (125a) vollständig freilegt.

9. Substratstruktur (100, 100') nach Anspruch 1, wobei die Lötmaskenschicht (150, 150', 150'') eine Vielzahl von Öffnungen (152") beinhaltet, die voneinander beabstandet sind, um eine Matrix von Öffnungen (152") zu bilden.

10. Paketbaugruppe (500), umfassend:
eine Substratstruktur (100, 100') nach einem der Ansprüche 1 bis 9; und
ein Chipgehäuse (200), das auf der Substratstruktur (100, 100') montiert ist.

## Revendications

1. Structure de substrat (100, 100'), comprenant :
une couche conductrice la plus supérieure (110) adjacente à une surface supérieure (100a) de la structure de substrat (100, 100'), dans laquelle la couche conductrice la plus supérieure (110) comprend :
une première partie de tampon (111) ; et
au moins une seconde partie de tampon (113) séparée de la première partie de tampon (111) et agencée près d'un coin de la première partie de tampon (111) ;
un premier via traversant, THV, et un second THV (125b) formés dans la structure de substrat (100, 100') et passant à travers la structure de substrat (100, 100'), le premier THV (125a) passant à travers la première partie de tampon (111) et le second THV (125b) passant à travers l'au moins une seconde partie de tampon (113) ; et
une première trace de pont (110a, 120a, 130a) formée dans la structure de substrat (100, 100') et reliée thermiquement au second THV (125b) et au premier THV (125a) ;
**caractérisée en ce que** la structure de substrat (100, 100') comprend également :
une couche conductrice la plus inférieure (120) adjacente à une surface inférieure (100b) de la structure de substrat (100, 100') ; et
une couche de masque de soudure (150, 150', 150") disposée sur la couche conductrice la plus inférieure (120), et comprenant au moins une ouverture (152, 152', 152") pour exposer au moins une partie du second THV (125b) et au moins une partie du premier THV (125a).

2. Structure de substrat (100, 100') selon la revendication 1, dans laquelle la première trace de pont (110a, 120a, 130a) est formée dans la couche conductrice la plus supérieure (110) ou dans une autre couche conductrice (120, 130) de la structure de substrat (100, 100') qui se trouve en dessous de la couche conductrice la plus supérieure (110).

3. Structure de substrat (100, 100') selon la revendication 2, comprenant également :
une seconde trace de pont (120a, 130a) reliée thermiquement au second THV (125b) et au premier THV (125a), et formée dans une couche conductrice (120, 130) de la structure de substrat (100, 100') qui est différente de la couche conductrice (110) dans laquelle la première trace de pont (110a) est formée.

4. Structure de substrat (100, 100') selon la revendication 1, dans laquelle la couche conductrice la plus supérieure (120) comprend une première trace de masse (121, 122), dans laquelle l'au moins une ouverture (152, 152', 152") expose également au moins une partie de la première trace de masse (121, 122).

5. Structure de substrat (100, 100') selon la revendication 4, dans laquelle la couche conductrice la plus inférieure (120) comprend également une trace d'alimentation/de signal (123) et une seconde trace de masse (121, 122) séparée de la première trace de masse (121, 122) par la trace d'alimentation/signal (123), dans laquelle la trace d'alimentation/de signal (123) est recouverte par la couche de masque de soudure (150, 150', 150"), et au moins une partie de la seconde trace de masse (121, 122) est exposée à partir de l'au moins une ouverture (152, 152', 152").

6. Structure de substrat (100, 100') selon la revendication 5, comprenant également :
un connecteur conducteur (210) couplant électriquement la première trace de masse (121, 122) et la seconde trace de masse (121, 122),
dans laquelle le connecteur conducteur (210) passe à travers l'au moins une ouverture (152, 152', 152"), et s'étend également sur la trace d'alimentation/signal (123).

7. Structure de substrat (100, 100') selon la revendication 1, dans laquelle la première trace de pont (110a, 120a, 130a) est connectée à une couche de masse électrique dans la structure de substrat (100, 100').

8. Structure de substrat (100, 100') selon la revendication 1, dans laquelle l'au moins une ouverture (152, 152', 152") est une ouverture unique (152') qui expose entièrement le second THV (125b) et le premier THV (125a).

9. Structure de substrat (100, 100') selon la revendication 1, dans laquelle la couche de masque de soudure (150, 150', 150") comporte une pluralité d'ouvertures (152") qui sont espacées les unes des autres pour former une matrice d'ouvertures (152").

10. Ensemble de conditionnement (500), comprenant :
une structure de substrat (100, 100') selon l'une quelconque des revendications 1 à 9 ; et
un boîtier de puce (200) monté sur la structure de substrat (100, 100').
